# EUROPÄISCHE PATENTSCHRIFT

(11) **EP 1 481 276 B1**
(45) Veröffentlichungstag und Bekanntmachung des Hinweises auf die Patenterteilung: **29.11.2006**
(21) Anmeldenummer: 03701529.4
(22) Anmeldetag: 20.01.2003
(51) Int. Cl.: G02B 19/00, G03F 7/20

(54) **BELEUCHTUNGSSYSTEM MIT GENESTETEM KOLLEKTOR ZUR ANNULAREN AUSLEUCHTUNG EINER AUSTRITTSPUPILLE**
LIGHTING SYSTEM COMPRISING A NESTED COLLECTOR FOR ANNULARLY ILLUMINATING AN EXIT PUPIL
SYSTEME D'ECLAIRAGE POURVU D'UN COLLECTEUR EMBOITE SERVANT A ECLAIRER UNE PUPILLE DE SORTIE DE MANIERE ANNULAIRE

(30) Priorität: 01.03.2002 DE 10208854
(43) Veröffentlichungstag der Anmeldung: 01.12.2004
(73) Patentinhaber: Carl Zeiss SMT AG, 73447 Oberkochen (DE)
(72) Erfinder: SINGER, Wolfgang, 73431 Aalen (DE); WANGLER, Johannes, 89551 Königsbronn (DE); SOHMEN, Eric, 73430 Aalen (DE)
(74) Vertreter: Sawodny, Michael-Wolfgang
(86) Internationale Anmeldenummer: PCT/EP2003/000491
(87) Internationale Veröffentlichungsnummer: WO 2003/075068

(56) Entgegenhaltungen:
- EP-A- 1 225 481
- US-A- 5 434 901
- US-A- 6 108 397
- US-B1- 6 210 865
- US-B1- 6 278 764
- US-B1- 6 285 737

## Beschreibung

Die Erfindung betrifft ein Beleuchtungssystem das eine Lichtquelle und eine Feldebene aufweist, umfassend wenigstens einen Kollektor mit wenigstens einer um eine Achse rotationssymmetrischen Spiegelschale zur Aufnahme eines Teiles des Lichtes der Lichtquelle, so dass eine im Lichtweg ausgehend von der Lichtquelle nach dem Kollektor angeordnete Aperturblendenebene annular ausgeleuchtet wird.

Aus der US 5,737,137 ist eine Projektionsbelichtungsanlage bekannt geworden, die eine Laserplasmaquelle als Lichtquelle umfaßt,. Das Beleuchtungssystem der Projektionsbelichtungsanlage gemäß der US 5,737,137 ist so aufgebaut das eine Austrittspupille des Beleuchtungssystems kreisförmig, d.h. annular, ausgeleuchtet wird. Um dies zu erreichen umfasst das Beleuchtungssystem eine Anordnung von drei Spiegeln, wobei zwei Spiegel ein inverses Cassegrain- oder Schwarzschild-System mit einer Obskuration von 25 % ausbilden. Die Spiegel des Schwarzschildsystems sind normal incidence Spiegel mit Vielfachschichtsystem, auf welche die Lichtstrahlen mit Winkeln im Bereich α < 30° auftreffen.

Das Projektionsobjektiv der aus der US 5,737,137 bekannten Projektionsbelichtungsanlage umfaßt zwei Spiegel mit einer Apertur, durch die das Licht hindurchtritt.

Des weiteren ist das System gemäß der US 5,737,137 ein System mit kritischer Beleuchtung.

Nachteilig an dem System gemäß der US 5,737,137 ist, daß im Beleuchtungssystem direkt hinter der Quelle ausschließlich normal-incidence-Spiegel eingesetzt werden. Zwar kann gemäß der US 5,737,137 der Eintritt von Debris in die Projektionsoptik verhindert werden, allerdings degradieren durch das Debris der Quelle sehr schnell die normal incidence Spiegel des Beleuchtungssystems. Durch die Degradation des Vielfachschichtsystems verlieren die normal incidence Spiegel im Zeitverlauf sehr stark an Reflektivität.

Ein weiterer Nachteil des Systems gemäß der US 5,737,137 ist, daß für eine homogene Ausleuchtung der Feldebene bei kritischer Beleuchtung mit einer kleinen Quelle ein sehr großer Abbildungsmaßstab erforderlich ist. Für sehr große Abbildungsmaßstäbe werden allerdings mit einem inversen Cassegrain- oder Schwarzschild-System die Dimensionen insbesondere des ersten Spiegels sehr groß und damit aufwendig in der Fertigung.

Aus der US 6,285,737 ist ein Beleuchtungssystem für eine Ringfeldkamera bekannt geworden, bei dem ein genesteter gracing incidence mirror ein Teil des Lichtes einer Lichtquelle aufnimmt und in einen in einer Feldebene angeordneten Schlitz abbildet.

Aus der US 5,434,901 A ist ein Röntgenmikroskop bekannt geworden, das ein Schwarzschild-System als optisches Element aufweist.

Die EP 1 225 481 A1 zeigt einen Kollektor für ein Beleuchtungssystem mit einer Vielzahl rotationssymmetrischer Spiegelschalen zur Verwendung In einem Beleuchtungssystem für eine Mikrolithographie-Projektionsbelichtungsanlage.

Aufgabe der Erfindung ist es, ein Beleuchtungssystem anzugeben, das eine annulare Ausleuchtung in einer Aperturblendenebene beziehungsweise einer hierzu konjugierten Ebene zur Verfügung stellt. Die Austrittspupille des Beleuchtungssystems, welche mit der Eintrittspupille des nachfolgendes Projektionsobjektives zusammenfällt, wird dann ebenfalls annular ausgeleuchtet. Die Nachteile des aus der US 5,737,137 bekannten Beleuchtungssystems sollen vermieden werden. Des weiteren soll mit dem erfindungsgemäßen Beleuchtungssystem eine homogene Ausleuchtung in einer Feldebene ermöglicht werden.

Erfindungsgemäß wird dies dadurch erreicht, daß ein Beleuchtungssystem einen Kollektor mit wenigstens einer um eine Achse rotationssymmetrischen Spiegelschale mit den Merkmalen des Anspruchs 1 umfaßt.

Ein derartiger Kollektor bildet bei entsprechender Ausgestaltung der Spiegelschalen eine vor dem Kollektor angeordnete Lichtquelle in ein reelles Lichtquellenbild, ab. Das reelle Lichtquellenbild wird auch als sekundäre Lichtquelle bezeichnet.

Erfindungsgemäß wird eine homogene Ausleuchtung einer Feldebene erreicht, indem die Spiegelschalen so dimensioniert werden, dass ein stark vergrößertes Bild der Lichtquelle defokussiert zu der Feldebene ausgebildet wird. Hierdurch ergibt sich in der Feldebene eine homogene Ausleuchtung in einem vorgegebenen Bereich. Die Beleuchtung Ist in einem solchen Fall nicht mehr kritisch.
Bevorzugt ist die Lage der homogen ausgeleuchteten Feldebene, die gegenüber der Lage des Lichtquellenbildes defokussiert ist, durch den Schnittpunkt eines ersten inneren Randstrahls eines ersten Lichtbüschels und eines zweiten inneren Randstrahl eines zweiten Lichtbüschels oder durch den Schnittpunkt eines ersten äußeren Randstrahls eine Lichtbüschels und eines zweiten äußeren Randstrahl eines Lichtbüschels bestimmt. Das erste und das zweite Lichtbüschel werden durch die ausgedehnte Lichtquelle und einen Aperturstrahl bestimmt. Eine Kollektorschale nimmt in einer bestimmten annularen Apertur von der Lichtquelle Strahlen auf. Zwischen innerem Aperturstrahl und äußerem Aperturstrahl der annularen Apertur ist ein erster mittlerer Aperturstrahl bestimmt, unter welchem ein Strahl von der Lichtquelle aus einen ersten Schnittpunkt mit der Kollektorschale definiert. Der bezüglich der Rotationsachse der Kollektorschale, auf oder in deren Nähe welcher sich die Lichtquelle befindet, gespiegelte mittlere Aperturstrahl zwischen Lichtquelle und Kollektorschale definiert einen zweiten mittleren Aperturstrahl und einen zweiten Schnittpunkt. Erster und zweiter Schnittpunkt liegen zusammen mit der optischen Achse damit in einer Meridonalebene. Das erste Lichtbüschel ist dabei das Lichtbüschel, das in dem ersten Schnittpunkt von der Kollektorschale von der ausgedehnten Lichtquelle aufgenommen wird. Das zweite Lichtbüschel ist das Lichtbüschel, das in einem zweiten Schnittpunkt von der Kollektorschale von der ausgedehnten Lichtquelle aufgenommen wird.

Bevorzugt wird in der Feldebene oder in einer hierzu konjugierten Ebene eine strukturierte Maske plaziert, die auf ein lichtempfindliches Objekt mittels eines Projektionsobjektives abgebildet wird.

Entscheidend für den erfindungsgemäßen Kollektor, der um eine Achse rotationssymmetrische Spiegelschalen umfaßt, ist, daß die aufgenommenen Strahlen unter einem Winkel > 70° zur Oberflächennormalen aufgenommen werden, d.h. es sich bei dem Kollektor um einen sogenannten grazing-incidence-Kollektor handelt.

Grazing-incidence-Kollektoren haben gegenüber normal-incidence-Koilektoren den Vorteil, daß sie durch den Debris der Quelle nur in geringem Maße degradieren, d.h. kaum an Reflektivität einbüßen. Des weiteren sind grazing-incidence-Spiegel stets einfacher aufgebaut, da sie in der Regel nur eine optische Beschichtung, vorzugsweise aus Ruthenium, Palladium, Rhodium oder Gold aufweisen. Desweiteren können Reflektivitäten > 80 % bei geringeren Anforderungen an die Oberflächenrauigkeit erreicht werden.

Der Kollektor umfasst nicht nur eine einzige rotationssymmetrische Spiegelschale, sondern eine Vielzahl derartiger rotationssymmetrischer Spiegelschalen, wobei die Spiegelschalen um eine gemeinsame Rotationsachse ineinander angeordnet sind.

Bevorzugt sind die Spiegelschalen derart angeordnet, daß die annularen Ausleuchtungen jeder Spiegelschale in der Aperturblendenebene für benachbarte Spiegelschalen kontinuierlich aneinander anschließen. Bevorzugt wird für jede einzelne Kollektorschale ein mittlerer Aperturstrahl definiert, so das für jede Kollektorschale unabhängig in derselben homogen ausgeleuchteten Feldebene eine homogene Ausleuchtung erzielt wird. In diesem Fall liegen die Bilder der Lichtquelle der einzelnen Kollektorschalen nicht in derselben Ebene.

Besonders bevorzugt sind Kollektoren mit zwei Reflektionen. Kollektoren mit zwei Reflektionen können beispielsweise als genestete Woltersysteme mit ersten Spiegelschalen, die ringförmige Ausschnitte von Hyperboloiden sind, und zweiten Spiegelschalen, die ringförmige Ausschnitte von Ellipsoiden sind, ausgebildet sein. Woltersysteme sind aus der Literatur, beispielsweise aus Wolter, Annalen der Physik 10, 94 - 114, 1952, bekannt. Betreffend Woltersysteme mit einem reellen Zwischenbild der Quelle, die durch die Kombination einer Hyperboloidfläche mit einer Ellipsoidfläche gebildet wird, wird auf J. Optics, Vol. 15, 270 - 280, 1984 verwiesen.

Ein besonderer Vorteil von Woltersystemen ist, daß bei einem Woltersystem mit zwei Reflexionen mit Einfallswinkel > 70° relativ zur Oberflächennormalen eine maximale Kollektionsapertur von Naₘₐₓ = 0,985 entsprechend einem Aperturwinkel von 80° erreicht werden kann. Man befindet bei dieser Ausführungsform immer noch im hochreflektierenden Bereich der Reflexion unter streifendem Einfall mit einer Reflektivität > 70 %.

Besonders bevorzugt ist es, wenn das Beleuchtungssystem zwischen Kollektor und Austrittspupille wenigstens zwei optische Elemente mit positiver Brechkraft besitzt. Hierdurch kann erreicht werden, daß die im Lichtweg beginnend bei der Lichtquelle nach der Aperturblendenebene, die eine konjugierte Ebene zur Austrittspupille des Beleuchtungssystems ist, liegende Feldebene in eine konjugierte Ebene abgebildet wird, die vor der Austrittspupille des Beleuchtungssystems zum Liegen kommt. In dieser zur Feldebene konjugierten Ebene kann dann die auszuleuchtende strukturierte Maske, insbesondere das Retikel, bei einer Projektionsbelichtungsanlage angeordnet werden.

Um im System möglichst wenig Lichtverluste zu haben, werden die beiden optischen Elemente mit positiver Brechkraft unter Winkeln > 70° bzw. < 20° zur Flächennormale betrieben. Ein weiterer Vorteil ist, daß unter diesem Winkel die Beleuchtung des Retikel unpolarisiert erfolgt.

Mit dem erfindungsgemäßen Beleuchtungssystem wird eine annulare Ausleuchtung in der Austrittspupille mit einem σₒᵤₜ ≥ 0,55 erreicht. Hierbei ist σₒᵤₜ durch den Quotienten aus den Sinus des Winkels zur optischen Achse des äußerem Randstrahls der annularen Beleuchtung und der Objektivapertur gegeben. Parallel kann ein σₗₙ über den inneren Randstrahl der annularen Beleuchtung definiert werden, für welchen Werte von σₗₙ < 0.35 ereicht werden können.

Um das Licht unterhalb des in der Feldebene angeordneten Retikels zu führen, wird mit Vorteil mindestens ein Umlenk- oder Ablenkungsspiegel als drittes optisches Element im Lichtweg zwischen erstem und zweitem optischen Element vorgesehen. Dieser Spiegel kann bevorzugt ein Planspiegel sein.

Um das Retikel in Reflexion betreiben zu können, wird es nicht exakt senkrecht zur optischen Achse angeordnet, sondern geneigt hierzu, wobei der Neigungswinkel etwa 3° zur konjugierten Feldebene betragen kann.

Neben dem Beleuchtungssystem stellt die Erfindung auch eine Projektionsbelichtungsanlage zur Verfügung, die sich dadurch auszeichnet, daß das Beleuchtungssystem mindestens einen Kollektor, der eine Spiegelschale, die um eine Achse rotationssymmetrisch angeordnet ist und Licht im streifenden Einfall, d.h. mit Winkeln > 70° zur Flächennormalen reflektiert, besitzt, sowie ein Projektionsobjektiv, das als Schwarzschild-System ausgebildet sein kann.

Die Erfindung soll nachfolgend anhand der Ausführungsbeispiel beispielhaft beschrieben werden.

Es zeigen:
- Figur 1:: den generellen Aufbau eines Beleuchtungssystems, das nicht Teil der Erfindung ist.
- Figur 2:: das Zustandekommen der homogenen Ausleuchtung in der Feldebene bei defokussierter Anordnung in Relation zur Lichtquelle
- Figur 3:: das Zustandekommen der homogenen Ausleuchtung in der Feldebene bei defokussierter Anordnung in Relation zur Lichtquelle mit unterschiedlichen Defokussierungen für verschiedene Kollektorschalen
- Figur 4:: die Energieverteilung in der Feldebene bei einem System gemäß Figur 2.
- Figur 5:: ein Beleuchtungssystem mit drei optischen Elementen
- Figur 6:: das geneigten Retikel
- Figur 7:: ein gefaltetes System mit insgesamt vier optischen Elementen
- Figur 8 :: eine erläuemde Skizze für die Koordinaten des genesteten Kollektors

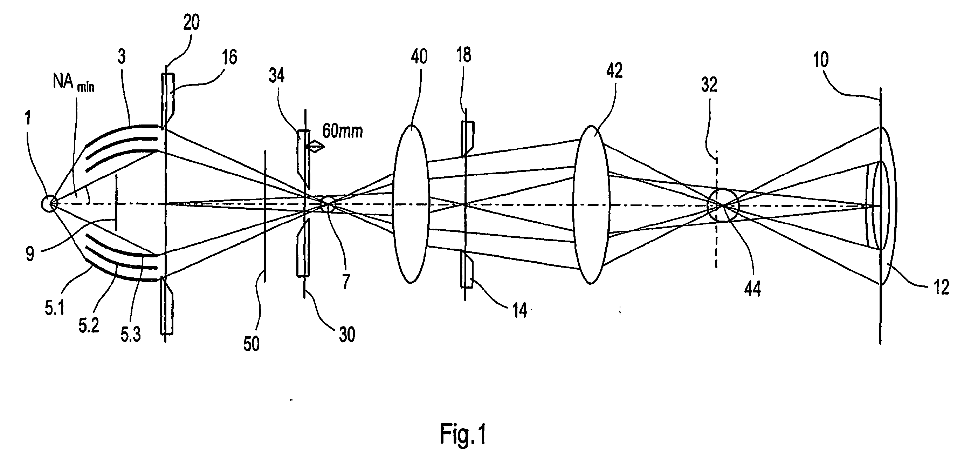

In Figur 1 ist beispielhaft in refraktiver Darstellung ein Beleuchtungssystem dargestellt, das nicht Teil der Erfindung ist. Das Beleuchtungssystem weist eine Lichtquelle 1 auf. Die Lichtquelle 1 ist bevorzugt eine Plasmaquelle, beispielsweise eine dense-plasma-focus-Quelle oder eine hollow-cathode-Quelle. Das Licht der Lichtquelle 1 wird von dem Kollektor 3 aufgenommen. Der schematisch dargestellte Kollektor 3 umfaßt in der dargestellten Ausführungsform insgesamt drei ineinander angeordnete Spiegelschalen 5.1, 5.2 und 5.3, die das Licht der Lichtquelle 1 unter streifendem Einfall aufnehmen und in ein Bild der Lichtquelle 7 abbilden. Genestete, reflektive Kollektoren wie der Kollektor 3 weisen notwendigerweise eine zentrale Abschattung auf, d.h. unterhalb einem bestimmten Aperturwinkel NAₘᵢₙ kann die Strahlung der Quelle nicht mehr aufgenommen werden. Diese Strahlung wird daher mit einer Blende abgeblockt, damit sie nicht in das nachfolgende Beleuchtungssystem gelangen kann. Die Blende ist in Figur 1 mit 9 bezeichnet.

Konjugiert zur Austrittspupille 10 des Beleuchtungssystems liegt die erste Aperturblendenebene 20, die im Lichtweg hinter dem Kollektor 3 liegt. Die Kollektorschalen 5.1, 5.2, 5.3 des Kollektors 3 sind so gewählt, daß in Verbindung mit den nachfolgend optischen Elementen in der Austrittspupille 10 des Beleuchtungssystems eine vorbestimmte Apertur 12 annular ausgeleuchtet wird. Die vorbestimmte Apertur 12 in der Austrittspupille 10 wird durch die Aperturblenden 16 in der ersten Aperturblendenebene begrenzt. Da in dem System eine weitere, zur ersten Aperturblendenebene 20 konjugierte Ebene 18 ausgebildet wird, kann dort eine alternative oder eine zweite Aperturblende 14 vorgesehen sein. Die zweite Aperturblende 14 in Ebene 18 hat den Vorteil, daß sie dort von geringerer Ausdehnung gewählt werden kann.

Aufgrund der nicht aufgenommen Apertur der Quellstrahlung unterhalb des minimalen Aperturwinkels NAₘᵢₙ stellt sich in der Aperturblendenebene 20 und in der hierzu konjugierten Ebene, in der die Austrittspupille10 zu Liegen kommt, zwangsläufig die gewünschte annulare Beleuchtung ein.

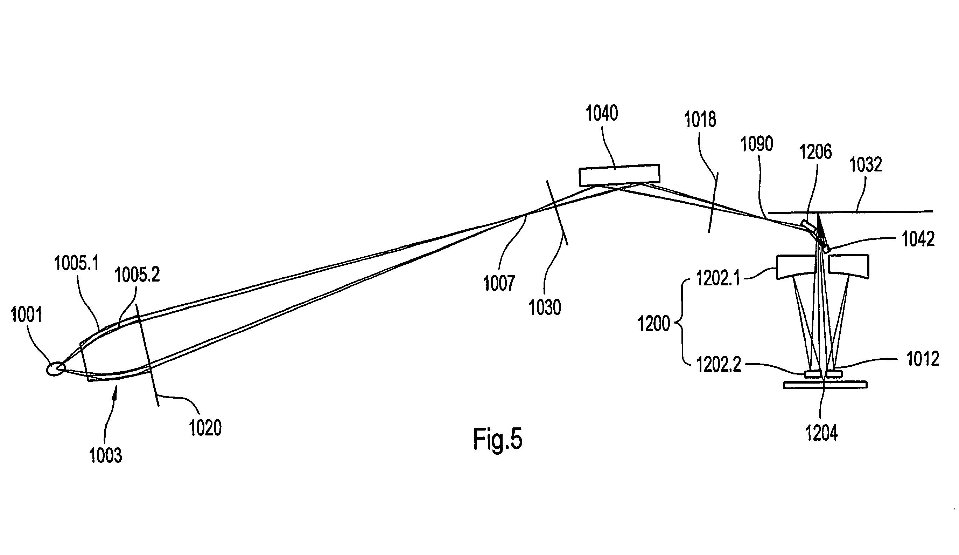

Um die vorbestimmte homogene Ausleuchtung in der Feldebene zu erhalten, wird die Lichtquelle 1 nicht exakt in die Feldebene abgebildet, sondern leicht defokussiert. Im vorliegenden Fall beträgt die Defokussierung zwischen dem Bild der Lichtquelle 7 und der zur Feldebene 30 etwa 60 mm. In der Feldebene 30 kann eine Feldblende 34 angeordnet sein. In der zur Feldebene 30 konjugierten Feldebene 32 wird die strukturierte Maske, das sogenannte Retikel, angeordnet, die mittels eines Projektionsobjektives, das beispielsweise in Figur 5 dargestellt ist, auf ein lichtempfindliches Objekt abgebildet wird. Die Feldblende 34 begrenzt das Strahlenbüschel auf die gewünschte Feldgröße von z.B. 3mm x 3mm auf der strukturtragenden Maske, blockiert die darüber hinaus gehende Strahlung und vermindert damit vorteilhafterweise die Wärmelast auf den nachfolgenden optischen Elementen.

Mit der Defokussierung des Bildes 7 der Lichtquelle gegenüber der Feldebene wird erreicht, daß die Homogenitätabweichungen der Ausleuchtung im auszuleuchtenden Bereich von etwa 3mm x 3mm in der Feldebene 32 weniger als ± 5 % beträgt.

In der in Figur 1 gezeigten Anordnung umfaßt das Beleuchtungssystem eine Kondensoropfik mit zwei optischen Elementen 40, 42 mit positiver optischer Brechkraft, um die Reihenfolge der Aperturblendenebene 20, die mit dem Ende des genesteten Kollektors 3 zusammenfällt, und der Feldebene 30, die nahe dem Zwischenbild 7 der Quelle liegt, zu vertauschen. Die optischen Elemente 40, 42 sind schematisch als refraktive Komponenten dargestellt, eine Ableitung für reflektive Komponenten ergibt sich in für den Fachmann naheliegender Weise. Die Feldebene, in der das Retikel angeordnet wird, ist die zur Feldebene 30 konjugierte Feldebene 32, die nach dem System aus dem ersten optischen Element 40 und dem zweiten optischen Element 42, ausgebildet wird und vor der Austrittspupille 10 liegt. Durch die beiden optischen Elemente 40, 42 wird wiederum ein Bild 44 des Lichtquellenbildes 7, eine sogenannte tertiäre Lichtquelle ausgebildet

In Figur 1 umfaßt das Beleuchtungssystem des weiteren bevorzugt einen Spektralfilter 50, um das Licht der Lichtquelle 1 zu filtern und nach dem Filter 50 Strahlung alleine der benötigten Wellenlänge, beispielsweise einer Wellenlänge von 13.5 nm, zur Verfügung zu stellen. Das Spektralfilter kann beispielsweise eine Zirkonfolie sein oder aber ein Gitterspektralfilter.

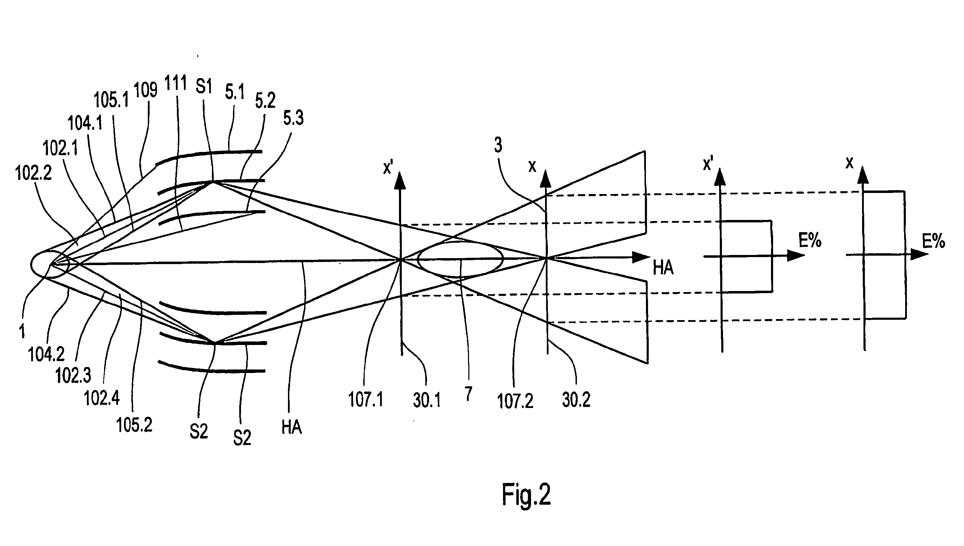

In Figur 2 ist nochmals dargestellt, wie durch vergrößerte Quelle und leichte Defokussierung der Feldebene 30.1 oder der alternativen Feldebene 30.2 zum Bild der Lichtquelle 7 eine homogene Ausleuchtung in den Feldebenen 30.1, 30.2 erreicht werden kann. Die primäre Lichtquelle 1 ist im vorliegenden Fall eine ausgedehnte Lichtquelle. Ein erster Punkt auf der Spiegelschale 5.2 des genesteten Kollektors, der durch den ersten Schnittpunkt S1 eines ersten mittleren Aperturstrahl 102.1 mit der Kollektorschale 5.2 des Kollektors in der Meridonalebene gegeben ist, nimmt ein erstes Strahlbüschel 102.2 der Lichtquelle 1 auf. Die Ausdehnung des Strahlbüschels ist durch die Ausdehnung der Lichtquelle 1 gegeben. Durch die Reflexion unter streifendem Einfall, d.h. unter einem Winkel >70° zur Oberflächennormalen an der Spiegelschale 5.2, wird ein Bild 7 der Lichtquelle 1 ausgebildet Die Größe des ausgebildeten Lichtquellenbildes wird durch die reflektierten Randstrahlen 104.1 und 105.1 und die Entfernung zum ersten Schnittpunkt S1 definiert. Als Meridonalebene wird in dieser Anmeldung eine Ebene verstanden, die die Rotationsachse HA umfasst.

In der Meridionalebene bezüglich der optischen Achse HA gespiegelt liegt gegenüber dem ersten mittlerem Aperturstrahl 102.1 und erstem Schnittpunkt S1 ein zweiter mittlerer Aperturstrahl 102.3 und ein zweiter Schnittpunkt S2 mit der Kollektorschale 5.2. Im zweiten Schnittpunkt S2 des Kollektors mit der Spiegelschale 5.2 wird ein zweites Strahlbüschel 102.4 der Lichtquelle 1 aufgenommen. Der zweite äußere Randstrahl 104.2 und der zweite innere Randstrahl 105.2 des zweiten Strahlbüschels 102.4 werden wieder durch die maximale Ausdehnung der Lichtquelle 1 bestimmt.
Die inneren Randstrahlen 105.1, 105.2 des ersten Lichtbüschels 102.2 und des zweiten Lichtbüschels 102.4, schneiden sich in einem Schnittpunkt 107.2 hinter dem Bild 7 der Lichtquelle 1 in einer Ebene 30.2. Vor dem Bild 7 der Lichtquelle 1 schneiden sich in einem Schnittpunkt 107.1 in einer Ebene 30.1 die äußeren Randstrahlen 104.1, 104.2 des ersten Lichtbüschels 102.2 und des zweiten Lichtbüschels 102.4.

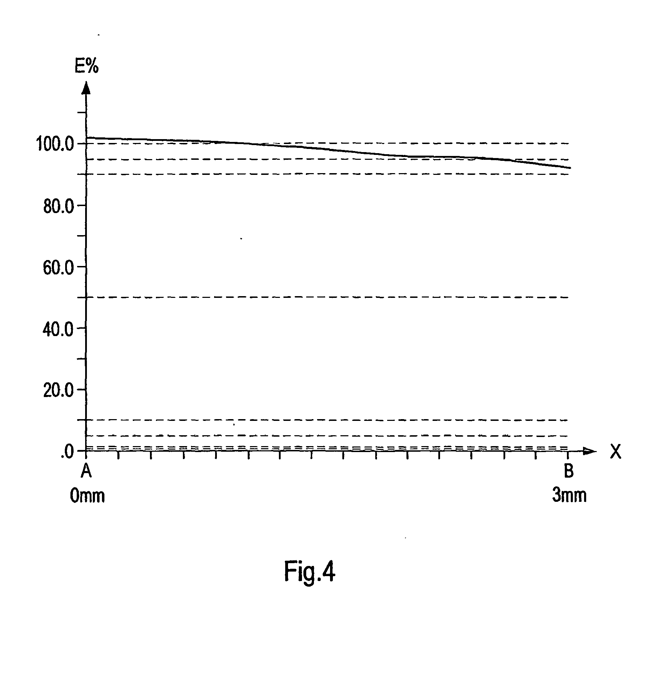

Entlang der x-Richtung ergibt sich in oder in der Nähe der Ebenen 30.1, 30.2 dann eine, wie in Figur 4 gezeigt, weitgehend homogene Ausleuchtung. Eine der Ebenen 30.1., 30.2 kann dann als Feldebene des Systems gewählt werden.

Während in Figur 2 für eine einzige Spiegelschale eines genesteten Kollektors gezeigt wurde, daß in Ebenen 30.1, 30.2 defokussiert zur sekundären Lichtquelle 7 eine homogene Ausleuchtung erreicht werden kann, ist es bei Systemen mit mehr als einer Schale ebenfalls möglich, in den Ebenen 30.1, 30.2 eine homogene Ausleuchtung zu erreichen. Gegenüber dem in Figur 1 beschriebenen Beispiel ändert sich nichts an der Ableitung außer der Wahl des mittleren Aperturstrahls. Der mittlere Aperturstrahl 102.1 wird bei dem in Figur 2 gezeigten Ausführungsbeispiel als der mittlerer Strahl zwischen einem äußeren Randstrahl 109 zwischen einem Punkt der Lichtquelle und der äußersten Schale 5.1 und einem innerem Randstrahl 111 zwischen dem Punkt der Lichtquelle und der innersten Schale 5.3 definiert

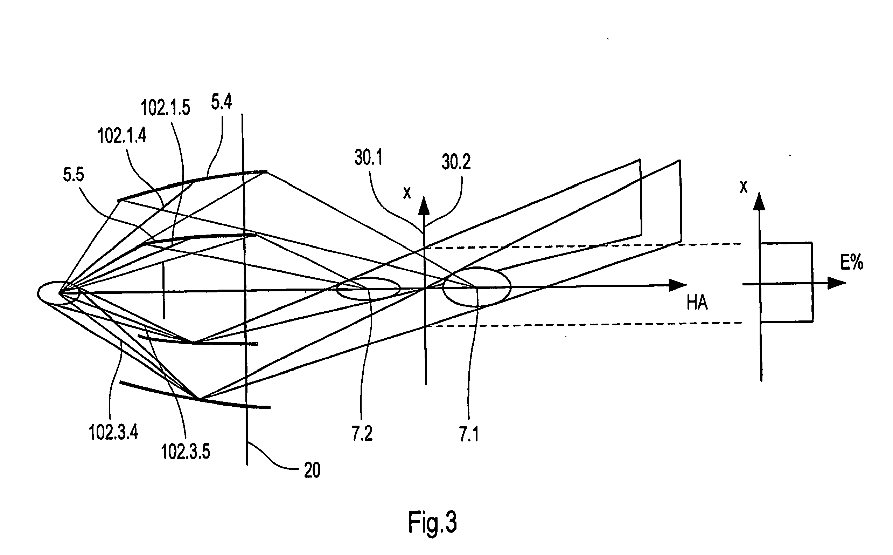

Wie in Fig. 3 gezeigt, kann bei Systemen mit mehr als einer Kollektorschale für verschiedene Kollektorschalen beispielsweise für die äußeren Schale 5.4 die vor dem Zwischenbild 7.1 der äußeren Schale 5.4 liegende Ebene 30.1 gewählt werden und für die innere Schale 5.5 die hinter dem Zwischenbild 7.2 liegende Ebene 30.2. Durch geeignete Wahl der Schalenparameter können die den jeweiligen Schalen zugeordneten Ebenen so verschoben werden, daß die Ebenen 30.1 und 30.2 zusammenfallen. Auf diese Weise wird eine noch bessere Durchmischung des Lichtes und eine weitere Verbesserung der Homogenität in der auszuleuchtenden Feldebene 30.1 und 30.2 erzielt. Die Schalenparameter können dabei so gewählt werden, daß sich in der Ebene 20 in oder hinter dem Kollektor eine annulare Ausleuchtung einstellt. Der mittlere erste Aperturstrahl der äußersten Schale 5.4 ist mit 102.1.4 bezeichnet, der mittlere zweite Aperturstrahl der äußersten Schale 5.4 mit 102.3.4, der mittlere erste Aperturstrahl der innersten Schale 5.5 ist mit 102.1.5 und der mittlere zweite Aperturstrahl der innersten Schale 5.5 mit 102.3.5 bezeichnet.

In Figur 5 ist ein System gemäß der Erfindung in reflektiver Darstellung gezeigt. Das in Figur 5 gezeigte System umfaßt neben dem Beleuchtungssystem die an das Beleuchtungssystem anschließende Projektionsoptik. Gleiche Bauteile wie in Figur 1 sind mit um 1000 höhere Bezugsziffern angegeben. Das Licht der Lichtquelle 1001 wird von dem genesteten Kollektor 1003 mit zwei Schalen 1005.1, 1005.2 aufgenommen. Es wird ein Bild der Lichtquelle 1001, die sogenannte sekundäre Lichtquelle 1007, ausgebildet. Mit Hilfe des grazing-incidence-Spiegels 1040 und des normal-incidence-Spiegels 1042, die dem ersten und zweiten optischen Element entsprechen, werden Feldebene und die Aperturblendenebene 1020 in ihrer Reihenfolge im Lichtweg vertauscht. Die konjugierte Feldebene 1032, in der gemäß der Erfindung eine strukturierte Maske homogen ausgeleuchtet wird, wird defokussiert zum Bild der sekundären Lichtquelle 1007, der sogenannten tertiären Lichtquelle, angeordnet. Diese Defokussierung ist in Figur 5 deutlich zu erkennen, da das tertiäre Lichtquellenbild 1090 bereits hinter der Aperturblende 1018 zum Liegen kommt.

Die Austrittspupille 1012 des Beleuchtungssystems stimmt mit der Eintrittspupille des als Schwarzschild-System ausgebildeten Projektionsobjektiv 1200 überein. Das Projektionsobjektiv 1200 umfaßt zwei Spiegel 1202.1 und 1202.2. Das lichtempfindliche Objekt, auf das die Maske abgebildet wird, befindet sich in der Ebene 1204. Um den Strahlengang unterhalb des Retikels, das in der konjugierten Feldebene 1032 angeordnet ist, zu halten, ist bei dem vorliegenden System ein drittes optisches Element 1206 vorgesehen, das den Strahl vom ersten optischen Element 1040 zum zweiten optischen Element 1042 umlenkt. Um die Reflexionsverluste minimal zu halten, fallen die Strahlen auf das erste optische Element 1040 unter einem Winkel >70° zur Oberflächennormalen auf und auf den normal-incidence-Spiegel 1042 mit Winkeln < 20° zur Oberflächennormalen. Weiterer Vorteil der Wahl dieser Einfallswinkel ist die weitgehende Unabhängigkeit der Reflektivität von der Polarisation des einfallenden Lichtes, so daß auf dem Retikel eine unpolarisierte Beleuchtung vorliegt.

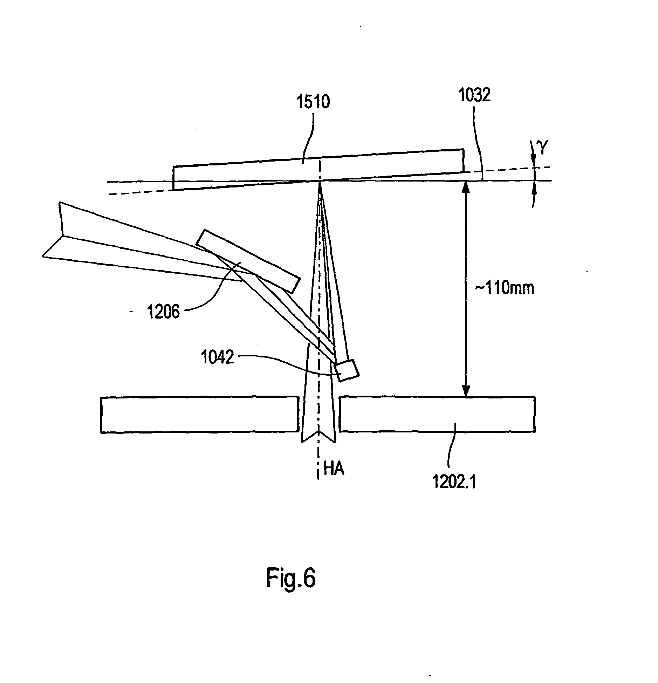

In Figur 6 ist noch einmal detaillierter das dritte optische Element 1206 sowie das zweite optische Element 1042 gezeigt. Deutlich zu erkennen die zur optischen Achse HA des Objektives 1200 zentrierte Anordnung des ersten Spiegels 1202.1 des Objektives 1200. Da in der EUV-Lithographie das Retikel in Reflexion betrieben werden muß, andererseits die optischen Elemente des vorliegenden Schwarzschild-Objektives zur optischen Achse HA zentriert angeordnet sind, wird das Retikel um mindestens den Aperturwinkel, vorliegend 3,44°, gegenüber der Feldebene geneigt. Der Neigungswinkel γ des Retikels 1510 zur Feldebene 1032 ist somit in vorliegendem Ausführungsbeispiel γ > 3,5°.

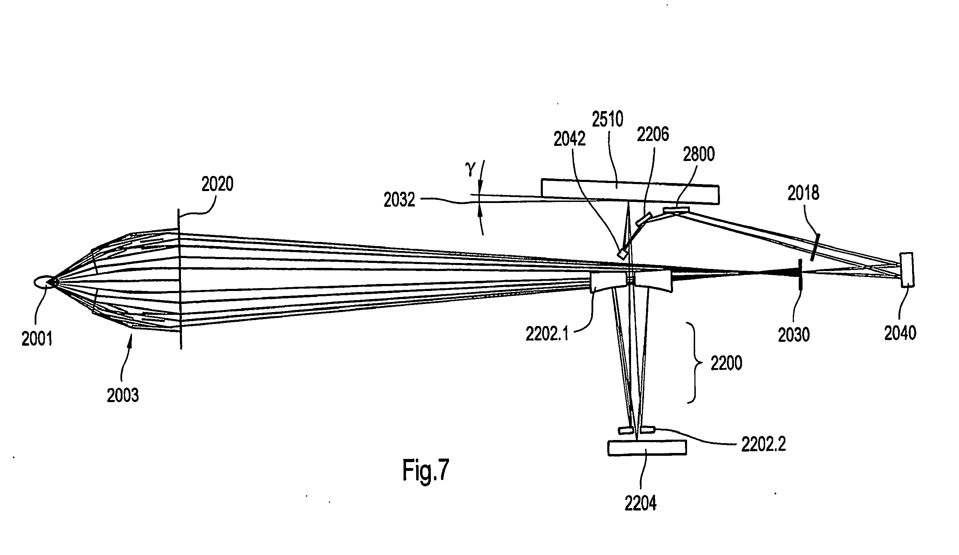

In Figur 7 ist ein alternatives System gemäß Tabellen 1 und 2 dargestellt, bei dem zur Verkürzung der Baulänge des Systems zusätzlich der Strahlengang von der Lichtquelle zur Feldebene gefaltet wird. Zusätzlich wird ein zweiter Planspiegel 2800 in den Strahlengang eingebracht, damit sich das Beleuchtungssystem vollständig unterhalb der Retikel-Ebene befindet. Gleiche Bauteile wie in den vorangegangenen Figuren sind mit denselben Bezugsziffem, erhöht um 1000 gegenüber Figur 4, bezeichnet. So bezeichnet 2001 die Lichtquelle, 2003 den genesteten Kollektor bestehend aus drei Schalen, 2020 die erste Aperturblendenebene, 2030 die konjugierte Feldebene, 2040 das erste optische Element, 2042 das zweite optische Element, 2200 das Projektionsobjektiv mit zwei Spiegeln 2202.1 und 2202.2 sowie 2510 das gegenüber der Feldebene 2032 geneigte Retikel und 2204 die Ebene, in der das lichtempfindliche Objekt angeordnet ist. Vorteilhafterweise wird der Kippwinkel des ersten optischen Element 2040 dabei so gewählt, daß der Strahlengang zwischen Lichtquelle 2001 und dem ersten optischen Element 2040 nicht in der derselben Ebene liegt, wie der Strahlengang der nachfolgenden optischen Elemente, wie auch des Retikels 2510 und dem lichtempfindlichen Objekt in Ebene 2204. In Figur 7 wird in der Feldebene 2030 das Strahlbüschel soweit begrenzt, dass das Retikel 2510 nurmehr auf einer Fläche von 3 mm x 3 mm ausgeleuchtet wird.

**Tab. 1 Parameter der optischen Elemente im Strahlengang nach dem Kollektor 2003**

| Ebene | Radius | Abstand zum nächsten Spiegel | Einfallswinkel des Haupstrahls zur Flächennormale |
|---|---|---|---|
| 2020 | Blendenebene | 1285mm | 0° |
| 2030 | Feldebene | 209.2 mm | 0° |
| 2040 | -330.5 mm | 185.8 mm | 7.25° |
| 2018 | Blendenebene | 290 mm | 0° |
| 2800 | plan | 70 mm | 75° |
| 2206 | plan | 70 mm | 72° |
| 2042 | -497.2 mm | 100 mm | -16° |
| 2032 | Refikel-Ebene | | |

**Tab. 2 : optische Daten des Kollektors 2003**

| | Hyperboloid | | | | |
|---|---|---|---|---|---|
| Schale | R [mm] | K | ZS [mm] | ZV [mm] | ZH [mm] |
| 1 | 3.5076 | -1.0399 | -1.74 | 107.56 | 182.35 |
| 2 | 5.0414 | -1.0571 | -2.49 | 105.05 | 179.53 |
| 3 | 7.2534 | -1.0814 | -3.56 | 102.83 | 177.68 |
| | | | | | |

| | Ellipsoid | | | | |
|---|---|---|---|---|---|
| Schale | R [mm] | K | ZS [mm] | ZV [mm] | ZH [mm] |
| 1 | 4.6059 | -0.9945 | -181.56 | 363.50 | 454.10 |
| 2 | 6.4739 | -0.9923 | -184.74 | 364.03 | 457.33 |
| 3 | 9.0813 | -0.9893 | -189.80 | 366.19 | 463.15 |

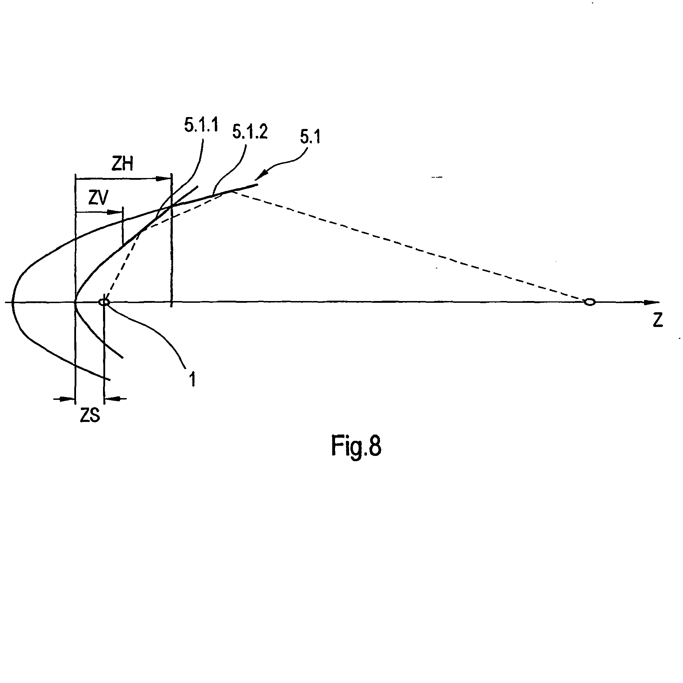

In Figur 8 und Tabelle 2 sind beispielhaft für die drei Spiegelschalen 5.1, 5.2, 5.3 des genesteten Kollektors 2003 aus Figur 7 die charakteristischen Daten eines Wolter-Systems umfassend je zwei Segmente, ein erstes hyperboloidförmiges Segement und ein zweites ellipsoidförmiges Segment pro Spiegelschale dargestellt. Für die erste Spiegelschale 5.1 bezeichnet 5.1.1 das erste ringförmige Segement und 5.1.2 das zweite ringförmige Segment Es bezeichnet ZS die z-Position des Flächenscheitels bezogen auf die Position der Lichtquelle 1, ZV und ZH die Anfangs- und Endposition des ersten Segmentes 5.1.1, das ein Hyperboloid ist, bezogen auf die Position des Flächenscheitels ZS. Für das zweite Segment 5.1.2 der Spiegelschale 5.1, das ein Ellipsoid ist, werden die Bezugszeichen ZS,ZH,ZV in analoger Art und Weise verwandt

Mit dem Krümmungsradius R und der konischen Konstante K des jeweiligen Spiegelsegmentes sowie den angegebenen Definitionen ergeben sich die Designdaten des Kollektors gemäß Figur 8 wie in Tabelle 2 angeben.

Mit der vorliegenden Erfindung wird erstmals ein System angegeben, bei dem eine homogene Ausleuchtung in einer Feldebene erzielt wird und Lichtverluste minimiert werden:

## Patentansprüche

1. Beleuchtungssystem für eine Projektionsbelichtungsanlage, wobei das Beleuchtungssystem eine Lichtquelle (1) für Wellenlängen ≤ 193nm Insbesondere ≤ 126 nm, besondere bevorzugt im EUV-Bereich aufweist, und die Projektionsbelichtungsanlage eine auszuleuchtende Feldebene (30) und eine hierzu konjugierte Feldebene (32) in der eine Maske angeordnet ist, hat,
und das Beleuchtungssystem umfasst:
wenigstens einen Kollektor (3), umfassend wenigstens eine erste (5.4) und eine zweite (5.5) um eine Achse (HA) rotationssymmetrische Spiegelschale zur Aufnahme eines Teiles des Lichtes der Lichtquelle (1) unter Einfallswinkeln bezüglich der Flächennormalen größer 70° und eine Aperturblende (20), wobei die im Lichtweg nach dem Kollektor (3) und vor der Feldebene (30) angeordnete Aperturblende (20) annular ausgeleuchtet wird,
**dadurch gekennzeichnet, dass**
- eine erste Spiegelschale (5.4) derart ausgebildet ist, dass ein erstes vergrößertes reelles Bild (7.1) der Lichtquelle (1) ausgebildet wird und
- eine zweite Spiegelschale (5,5) derart ausgebildet ist, dass ein zweites vergrößertes reelles Bild (7.2) der Lichtquelle (1) ausgebildet wird und das erste (7.1) und zweite (7.2) vergrößerte reelle Bild der Lichtquelle an unterschiedlichen Orten entlang der Achse (HA) zu liegen kommen, wobei das erste vergrößerte reelle Bild (7.1) der Lichtquelle und das zweite vergrößerte Bild (7.2) der Lichtquelle zur Feldebene (30) defokussiert sind.

2. Beleuchtungssystem nach Anspruch 1, **dadurch gekennzeichnet, dass** das erste vergrößerte Bild (7.1) der Lichtquelle und/ oder das zweite vergrößerte Bild (7.2) der Lichtquelle um mehr als 30 mm, bevorzugt mehr als 50 mm zur Feldebene defokussiert ist.

3. Beleuchtungssysteme nach Anspruch 1 oder 2, **dadurch gekennzeichnet, dass** das erste vergrößerte Bild (7.1) der Lichtquelle im Lichtweg von der Lichtquelle (1) zur konjugierten Feldebene (32) nach der Feldebene (30) zu liegen kommt.

4. Beleuchtungssysteme nach einem der Ansprüche 1 bis 3, **dadurch gekennzeichnet, dass** das zweite vergrößerte Bild (7.2) der Lichtquelle im Lichtweg von der Lichtquelle (1) zur konjugierten Feldebene (32) vor der Feldebene (30) zu liegen kommt.

5. Beleuchtungssystem nach einem der Ansprüche 1 bis 4, **dadurch gekennzeichnet, dass** das erste vergrößerte Bild (7.1) ein erstes stark vergrößertes Bild (7.1) mit einem Abbildungsmaßstab β > 2, bevorzugt β > 5 ist.

6. Beleuchtungssystem nach einem der Ansprüche 1 bis 5, **dadurch gekennzeichnet, dass** das zweite vergrößerte Bild (7.2) ein zweites stark vergrößertes Bild (7.2) mit einem Abbildungsmaßstab β > 2, bevorzugt β > 5 ist.

7. Beleuchtungssysteme nach einem der Ansprüche 1 bis 6, **dadurch gekennzeichnet, dass** die erste Spiegelschale (5.4) und die zweite Spiegelschale (5.5) um die gemeinsame Achse (HA) ineinander angeordnet sind.

8. Beleuchtungssystem nach einem der Ansprüche 1 bis 7, **dadurch gekennzeichnet, dass** die erste (5.4) und/oder die zweite Spiegelschale (5.5) ein erstes Segment mit einer optischen Fläche umfasst.

9. Beleuchtungssystem nach Anspruch 8, **dadurch gekennzeichnet, dass** das erste Segment ein Ausschnitt eines Hyperboloides und das zweite Segment der Ausschnitt eines Ellipsoides ist.

10. Beleuchtungssystem nach einem der Ansprüche 1 bis 9, **dadurch gekennzeichnet, dass** das Beleuchtungssystem wenigstens ein erstes (40) und ein zweites optisches Element (42) mit Brechkräften umfasst.

11. Beleuchtungssystem nach Anspruch 10, **dadurch gekennzeichnet, dass** das erste optische Element (40) ein grazing-incidence-Spiegel ist, auf dem die Strahlen unter Winkeln α > 70° zur Flächennormalen auftreffen.

12. Beleuchtungssystem nach Anspruch 11, **dadurch gekennzeichnet, dass** das erste optische Element (40) ein normal-incidence-Spiegel ist, auf dem die Strahlen unter Winkeln α > 30° zur Flächennormalen auftreffen.

13. Beleuchtungssystem nach einem der Ansprüche 11 oder 12, **dadurch gekennzeichnet, dass** das zweite optische Element (42) ein normal-Incidence-Spiegel ist, auf den die Strahlen unter einem Winkel α < 20° zur Flächennormalen auftreffen.

14. Beleuchtungssystem nach einem der Ansprüche 11 bis 13 **dadurch gekennzeichnet, dass** das Beleuchtungssystem mindestens ein drittes (1206, 2206) oder weitere optische Element (2800) umfasst.

15. Beleuchtungssystem nach Anspruch 14, **dadurch gekennzeichnet, dass** das dritte oder die weiteren optischen Elemente Planspiegel sind.

16. Projektionsbelichtungsanlage für die Mikrolithographie mit
- einem Beleuchtungssystem gemäß einem der Ansprüche 1 bis 15, wobei die Maske, die von dem Beleuchtungssystem ausgeleuchtet wird, in der konjugierten Feldebene (32) angeordnet ist und
- einem Projektionsobjektiv (1200, 2200) zur Abbildung der Maske auf ein lichtsensitives Objekt.

17. Projektionsbelichtungsanlage nach Anspruch 16, **dadurch gekennzeichnet, dass** das Projektionsobjektiv (1200, 2200) ein Schwarzschild-System ist.

18. Projektionsbelichtungsanlage nach Anspruch 16 oder 17, **dadurch gekennzeichnet, dass** die Maske unter einem Neigungswinkel γ gegenüber der konjugierten Feldebene (1032) angeordnet ist.

19. Projektionsbelichtungsanlage nach Anspruch 18, **dadurch gekennzeichnet, dass**
der Neigungswinkel γ gegenüber der konjugierten Feldebene (1032) γ > 3,5° ist.

20. Verfahren zur Herstellung von mikroelektronischen Bauteilen, insbesondere Halbleiterbautellen, mit einer Projektionsbelichtungsanlage gemäß einem der Ansprüche 16 bis 19.

## Claims

1. An illumination system for a projection exposure system, with the illumination system comprising a light source (1) for wavelengths ≤ 193 nm, especially ≤ 126 nm, more preferably in the EUV range, and the projection exposure system comprises a field plane (30) to be illuminated and a field plane (32) which is conjugated thereto and in which a mask is arranged, and the illumination system comprises as follows:
- at least one collector (3), comprising at least a first (5.4) and a second (5.5) mirror dish which is rotationally symmetric about an axis (HA) for receiving a part of the light of the light source (1) under angles of incidence relative to the surface normal of larger 70° and an aperture stop (20), with the aperture stop (20) which is arranged in the light path after the collector (3) and before the field plane (30) is illuminated annularly,
**characterized in that**
- a first mirror dish (5.4) is arranged in such a way that a first enlarged real image (7.1) of the light source (1) is formed, and
- a second mirror dish (5.5) is arranged in such a way that a second enlarged real image (7.2) of the light source is formed, and the first (7.1) and second (7.2) enlarged real image of the light source comes to lie at different locations along the axis (HA), with the first enlarged real image (7.1) of the light source and the second enlarged image (7.2) of the light source are defocused relative to the field plane (30).

2. An illumination system according to claim 1, **characterized in that** the first enlarged image (7.1) of the light source and/or the second enlarged image (7.2) of the light source is defocused by more than 30 mm, preferably more than 50 mm relative to the field plane.

3. An illumination system according to claim 1 or 2, **characterized in that** the first enlarged image (7.1) of the light source comes to lie in the light path from the light source (1) to the conjugated field plane (32) after the field plane (30).

4. An illumination system according to one of the claims 1 to 3, **characterized in that** the second enlarged image (7.2) of the light source comes to lie in the light path from the light source (1) to the conjugated field plane (32) before the field plane (30).

5. An illumination system according to one of the claims 1 to 4, **characterized in that** the first enlarged image (7.1) is a first strongly enlarged image (7.1) with a linear magnification β > 2, preferably β > 5.

6. An illumination system according to one of the claims 1 to 5, **characterized in that** the second enlarged image (7.2) is a second strongly enlarged image (7.2) with a linear magnification β > 2, preferably β > 5.

7. An illumination system according to one of the claims 1 to 6, **characterized in that** the first mirror shell (5.4) and the second mirror shell (5.5) are arranged in each other about the common axis (HA).

8. An illumination system according to one of the claims 1 to 7, **characterized in that** the first (5.4) and/or the second mirror shell (5.5) comprises a first segment with an optical surface.

9. An illumination system according to claim 8, **characterized in that** the first segment is a section of a hyperboloid and the second section is the section of an ellipsoid.

10. An illumination system according to one of the claims 1 to 9, **characterized in that** the illumination system comprises at least one first (40) and second optical element (42) with refractive powers.

11. An illumination system according to claim 10, **characterized in that** the first optical element (40) is a grazing-incidence mirror on which the rays impinge under angles of α > 70° relative to the surface normal.

12. An illumination system according to claim 11, **characterized in that** the first optical element (40) is a normal-incidence mirror on which the rays impinge under angles α > 30° relative to the surface normal.

13. An illumination system according to one of the claims 11 or 12, **characterized in that** the second optical element (42) is a normal-incidence mirror on which the rays impinge under an angle α < 20° relative to the surface normal.

14. An illumination system according to one of the claims 11 or 13, **characterized in that** the illumination system comprises at least a third (1206, 2206) or further optical elements (2800).

15. An illumination system according to claim 14, **characterized in that** the third or further optical elements are plane mirrors.

16. A projection exposure system for microlithography, comprising
- an illumination system according to one of the claims 1 to 15, with the mask illuminated by the illumination system being arranged in the conjugated field plane (32), and
- a projection lens (1200, 2200) for projecting the mask onto a light-sensitive object.

17. A projection exposure system according to claim 16, **characterized in that** the projection lens (1200, 220) is a Schwarzschild system.

18. A projection exposure system according to claim 16 or 17, **characterized in that** the mask is arranged under angle of inclination γ relative to the conjugated field plane (1032).

19. A projection exposure system according to claim 18, **characterized in that** the angle of inclination γ is > 3.5° relative to the conjugated field plane (1032).

20. A method for producing microelectronic components, especially semiconductor components, comprising a projection exposure system according to one of the claims 16 to 19.

## Revendications

1. Système d'éclairage pour une installation d'éclairage de projection, dans lequel le système d'éclairage comprend une source lumineuse (1) émettant dans des longueurs d'ondes ≤ 193 nm et en particulier ≤ 126 nm, de préférence dans la plage des EUV, et l'installation d'éclairage de projection possède un plan de champ (30) à éclairer et un plan de champ (32) conjugué à celui-ci dans lequel un masque est disposé,
et le système d'éclairage comprend :
- au moins un collecteur (3), comprenant une première cuvette de miroir (5.4) et une deuxième (5.5) symétriques en rotation autour d'un axe (HA) pour recevoir une partie de la lumière de la source lumineuse (1) sous des angles d'incidence par rapport à la normale de surface supérieurs à 70° et un diaphragme d'ouverture (20), le diaphragme d'ouverture (20) disposé avant le plan de champ (30) et après le collecteur (3) dans le trajet de la lumière recevant un éclairage annulaire,
**caractérisé en ce que**
- une première cuvette de miroir (5.4) est conformée de façon à former une première image réelle agrandie (7.1) de la source lumineuse (1) et
- une seconde cuvette de miroir (5.5) est conformée de façon à former une seconde image réelle agrandie (7.2) de la source lumineuse (1) et les première (7.1) et seconde (7.2) images réelles agrandies de la source lumineuse se placent à des endroits différents le long de l'axe, la première image réelle agrandie (7.1) de la source lumineuse et la deuxième image agrandie (7.2) de la source lumineuse étant défocalisées par rapport au plan de champ (30).

2. Système d'éclairage selon la revendication 1, **caractérisé en ce que** la première image agrandie (7.1) de la source lumineuse et/ou la seconde image agrandie (7.2) de la source lumineuse sont défocalisées de plus de 30 mm, de préférence plus de 50 mm par rapport au plan de champ.

3. Système d'éclairage selon la revendication 1 ou 2, **caractérisé en ce que** la première image agrandie (7.1) de la source lumineuse se place après le plan de champ (30) sur le trajet de la lumière entre la source lumineuse (1) et le plan de champ conjugué (32).

4. Système d'éclairage selon l'une des revendications 1 à 3, **caractérisé en ce que** la seconde image agrandie (7.2) de la source lumineuse se place avant le plan de champ (30) sur le trajet de la lumière entre la source lumineuse (1) et le plan de champ conjugué (32).

5. Système d'éclairage selon l'une des revendications 1 à 4, **caractérisé en ce que** la première image agrandie (7.1) est une image très agrandie (7.1) avec une échelle de reproduction β > 2, de préférence β > 5.

6. Système d'éclairage selon l'une des revendications 1 à 5, **caractérisé en ce que** la seconde image agrandie (7.2) est une image très agrandie (7.2) avec une échelle de reproduction β > 2, de préférence β > 5.

7. Système d'éclairage selon l'une des revendications 1 à 6, **caractérisé en ce que** la première cuvette de miroir (5.4) et la seconde cuvette de miroir (5.5) sont disposées l'une dans l'autre autour de l'axe commun (HA).

8. Système d'éclairage selon l'une des revendications 1 à 7, **caractérisé en ce que** la première cuvette de miroir (5.4) et/ou la seconde (5.5) comprennent un premier segment avec une surface optique.

9. Système d'éclairage selon la revendication 8, **caractérisé en ce que** le premier segment est une partie d'hyperboloïde et le second segment une partie d'ellipsoïde.

10. Système d'éclairage selon l'une des revendications 1 à 9, **caractérisé en ce que** le système d'éclairage possède au moins un premier élément optique (40) et un deuxième (42) ayant des pouvoirs réfringents.

11. Système d'éclairage selon la revendication 10, **caractérisé en ce que** le premier élément optique (40) est un miroir à incidence rasante, que les rayons touchent sous des angles α > 70° par rapport à la normale de surface.

12. Système d'éclairage selon la revendication 11, **caractérisé en ce que** le premier élément optique (40) est un miroir à incidence normale, que les rayons touchent sous des angles α > 30° par rapport à la normale de surface.

13. Système d'éclairage selon l'une des revendications 11 ou 12, **caractérisé en ce que** le second élément optique (42) est un miroir à incidence normale, que les rayons touchent sous des angles α < 20° par rapport à la normale de surface.

14. Système d'éclairage selon l'une des revendications 11 à 13, **caractérisé en ce que** le système d'éclairage comprend au moins un troisième élément optique (1208, 2206) ou d'autres éléments optiques (2800).

15. Système d'éclairage selon la revendication 14, **caractérisé en ce que** le troisième élément optique ou les autres éléments optiques sont des miroirs plans.

16. Installation d'éclairage de projection pour la microlithographie avec un système d'éclairage selon l'une des revendications 1 à 15, dans lequel le masque éclairé par le système d'éclairage est disposé dans le plan de champ conjugué (32) et il est prévu un objectif de projection (1200, 2200) pour copier le masque sur un objet photosensible.

17. Installation d'éclairage de projection selon la revendication 16, **caractérisée en ce que** l'objectif de protection (1200, 2200) est un système Schwarzschild.

18. Installation d'éclairage de projection selon la revendication 16 ou 17, **caractérisée en ce que** le masque est disposé selon un angle d'inclinaison γ par rapport au plan de champ conjugué (1032).

19. Installation d'éclairage de projection selon la revendication 18, **caractérisé en ce que** l'angle d'inclinaison γ par rapport au plan de champ conjugué (1032) est de γ > 3,5°.

20. Procédé de fabrication de composants microélectroniques, en particulier de composants semi-conducteurs, avec une installation d'éclairage de projection selon l'une des revendications 16 à 19.
